Europäisches Patentamt

European Patent Office

Office européen des brevets

(19)

(11) Veröffentlichungsnummer: **0 144 822**
**B1**

(12)

# EUROPÄISCHE PATENTSCHRIFT

(45) Veröffentlichungstag der Patentschrift:
20.09.89

(21) Anmeldenummer: 84113719.3

(22) Anmeldetag: 14.11.84

(51) Int. Cl.⁴: **B 32 B 15/04**, B 32 B 31/08, B 32 B 31/20, H 05 K 3/38

(54) Verfahren und Vorrichtung zur kontinuierlichen Herstellung metallkaschierter Laminate.

(30) Priorität: 25.11.83 DE 3342678

(43) Veröffentlichungstag der Anmeldung:
19.06.85 Patentblatt 85/25

(45) Bekanntmachung des Hinweises auf die Patenterteilung: 20.09.89 Patentblatt 89/38

(84) Benannte Vertragsstaaten:
FR GB IT SE

(56) Entgegenhaltungen:
EP–A– 0 120 192
DE–A– 2 254 372
FR–A– 2 287 714
GB–A– 2 059 340
US–A– 3 404 424
US–A– 3 575 762
US–A– 4 225 376

(73) Patentinhaber: Held, Kurt
Alte Strasse 1
D-7218 Trossingen 2 (DE)

(72) Erfinder: Held, Kurt
Alte Strasse 1
D-7218 Trossingen 2 (DE)

(74) Vertreter: Hoeger, Stellrecht & Partner
Uhlandstrasse 14 c
D-7000 Stuttgart 1 (DE)

## Beschreibung

Die Erfindung betrifft ein Verfahren zur kontinuierlichen Herstellung metallkaschierter Laminate nach dem Oberbegriff des Patentanspruchs 1. Weiterhin bezieht sich die Erfindung auch auf eine Vorrichtung zur Durchführung eines solchen Verfahrens gemäß Patentanspruchs 8.

Metallkaschierte Laminate, insbesondere zur Herstellung von geätzten Leiterplatten, müssen mit einer Oberfläche hergestellt werden, die nach dem Verpressen völlig frei ist von Fremdkörpereindrücken, Harzrückständen, Kratzern und anderen Oberflächenschäden.

Es ist bekannt (US-A-3 575 762), beim Aufkaschieren einer Metallfolie auf einen Thermoplastfilm die Metallfolie bereits auf ihrer Vorratsrolle in einem Ofen vorzuheizen. Die vorbeheizte Metallfolie wird anschließend über eine einfache, vorbeheizte Walze geführt und dort mit der frisch extrudierten Thermoplastfolie vereinigt. Es ist ferner in der älteren EP-A-0 120 192 (Priorität : 01.03.83 ; Anmeldungstag 14.01.84 ; Veröffentlichungstag : 03.10.84) beschrieben, metallkaschierte Laminate auf Doppelbandpressen, also mit Hilfe zweier je über zwei Trommeln geführter Preßbänder, kontinuierlich herzustellen. Dabei wird die zulaufende Metallfolie vor ihrer Verbindung mit der Kernschicht durch Anlegen an ein heißes Preßband der Doppelbandpresse vorgeheizt. Eine gleichmäßige Aufheizung der Metallfolie ist hierbei nicht möglich, denn es treten infolge thermischer Verwerfungen Falten in der Metallfolie auf, welche die Oberflächengüte des Laminats herabsetzen. Außerdem konnten bei dieser Art der Herstellung metallkaschierter Laminate mit Hilfe einer Doppelbandpresse Verunreinigungen der Metallfolie mit Staub, der aus der Kernschicht oder der Umgebung stammt, nicht sicher ausgeschlossen werden.

Es ist Aufgabe der Erfindung, die Oberflächengüte von metallkaschierten Laminaten zu verbessern und dabei in erster Linie thermische Verwerfungen zu vermeiden sowie die Oberfläche von Verunreinigungen freizuhalten.

Die Aufgabe wird erfindungsgemäß durch die kennzeichnenden Merkmale des Patentanspruchs 1 gelöst.

Die nachstehende Beschreibung bevorzugter Ausführungsformen der Erfindung dient im Zusammenhang mit beiliegender Zeichnung der weiteren Erläuterung. Es zeigen :

Fig. 1 schematisch eine Schnittansicht einer Doppelbandpresse mit Metallfolien-Vorratsrollen zur kontinuierlichen Herstellung metallkaschierter Laminate ;

Fig. 2 eine abgewandelte Ausführungsform einer Vorrichtung zur Herstellung metallkaschierter Laminate ;

Fig. 3 eine vergrößerte Einzelansicht des Bereiches A in Fig. 2 und

Fig. 4 eine weitere Einzelansicht der Vorrichtung in Richtung des Pfeiles B in Fig. 3.

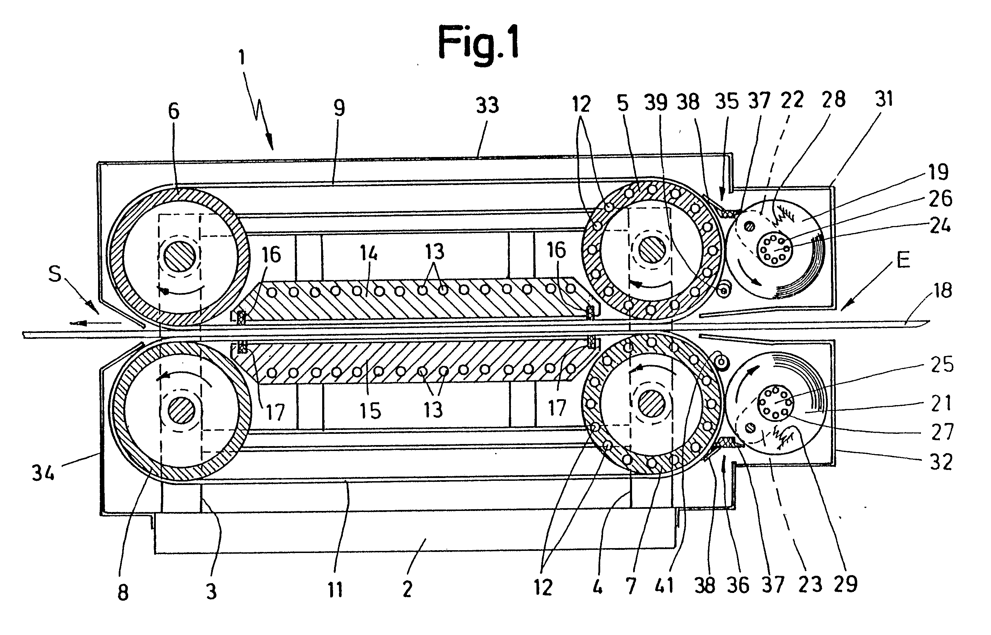

Die in Fig. 1 schematisch dargestellte Doppelbandpresse 1 umfaßt ein Maschinengestell mit Basisplatte 2 und zwei vertikalen Ständern 3, 4, die von der Basisplatte 2 abstehen. An den Ständern 3, 4 sind vier Umlenktrommeln 5, 6, 7, 8 drehbar gelagert. Um die Trommeln 5, 6 und 7, 8 verläuft jeweils ein vorzugsweise aus Metall bestehendes, endloses Preßband 9 bzw. 11. Die einlaufseitigen Umlenktrommeln 5, 7 sind beheizbar, beispielsweise durch im Trommelmantel verlaufende Leitungen 12 für ein wärmeabgebendes Medium. Die Wärme von den Trommeln 5, 7 geht auf die Preßbänder 9, 11 über. Die auslaufseitigen Umlenktrommeln 6, 8 sind in Pfeilrichtung angetrieben und nehmen die Preßbänder 9, 11 mit. Im Innern der Preßbänder 9, 11 sind vom Maschinengestell getragene, z. B. durch Heizröhren 13 aufgeheizte Druckplatten 14 bzw. 15 angeordnet. An der der jeweiligen Preßbandinnenseite zugewandten Fläche dieser Druckplatten 14, 15 sind in sich geschlossene Dichtungen 16 bzw. 17 angeordnet, die an der Preßbandinnenseite schleifen und einen Raum zum Eingeben eines vorzugsweise hydraulischen Druckmediums begrenzen. Hierdurch kann auf einen zwischen den Preßbändern 9, 11 vorgeschobenen, bahnförmigen Werkstoff gleichzeitig mit Wärme und Druck eingewirkt werden.

Bei der in Fig. 1 dargestellten Vorrichtung wird als bahnförmiger Werkstoff eine elektrisch isolierende Kernschicht 18 an der Einlaufseite E der Doppelbandpresse zugeführt. Diese Kernschicht besteht beispielsweise aus mit Kunstharz getränktem Papier, welches durch Armierungsfasern, insbesondere Glasfasern, verstärkt sein kann. Die Kernschicht 18 wird von einer nicht dargestellten Vorratsrolle abgezogen.

Vor den einlaufseitigen Umlenktrommeln 5, 7 sind Vorratsrollen 19, 21 für dünne Metallfolie, insbesondere Kupferfolie, jeweils schwenkbar an Armen 22, 23 gelagert. Die Vorratsrollen umfassen jeweils einen an den Armen 22, 23 drehbar gelagerten Kern 24, 25, auf den die bahnförmige Metallfolie aufgewickelt ist. Im Betrieb der Vorrichtung läuft die Metallfolie von den Vorratsrollen 19, 21, die in Pfeilrichtung umlaufen, im Bereich der Umlenktrommeln 5, 7 auf das Preßband 9 bzw. 11 auf, wird von diesem mitgenommen, auf die Kernschicht 18 aufgebracht und beim weiteren Durchlaufen der Doppelbandpresse 1 unter Druck- und Wärmeeinwirkung fest mit dieser Schicht verbunden, so daß an der Auslaufseite S der Vorrichtung schließlich ein doppelseitig metallkaschiertes Laminat ausläuft, bei dem die Metallfolien innig mit der Kernschicht verbunden sind. Wird in der Mitte der Kernschicht 18 eine Trennfolie mit durch die Vorrichtung hindurchgeführt und das Laminat nach dem Verlassen der Doppelbandpresse an dieser Trennfolie getrennt, so entstehen zwei einseitig kaschierte Metallaminate. Beide drehbaren Kerne 24, 25 der Vorrartsrolle 19, 21 sind abgebremst, so daß die Metallfolie mit gewisser Vorspannung von der Vorratsrolle abgezogen werden muß.

Wie eingangs bereits erwähnt, ist es für die Herstellung fehlerfreier metallkaschierter Laminate von entscheidender Bedeutung, thermische Verwerfungen der aufzubringenden Metallfolie (infolge unterschiedlicher Wärmeausdehnungen) zu verhindern. Um dies zu erreichen, muß die Metallfolie gleichmäßig vorgeheizt werden, und zwar vorzugsweise auf die Temperatur der Preßbänder 9, 11. Es wurde gefunden, daß ein einfacher, platzsparender Weg, die Metallfolie vorzuheizen, darin besteht, die Kerne 24, 25 aufzuheizen, beispielsweise durch in den Kernen angeordnete, elektrische Widerstandsheizungen oder Heizrohre, was in Fig. 1 durch die Bezugszeichen 26, 27 angedeutet ist. Innerhalb der Vorratsrolle liegen die einzelnen Schichten der Metallfolie dicht übereinander, so daß ein guter Wärmeleitungskontakt gewährleistet ist. Auf diese Weise ergibt sich eine vollkommen gleichmäßige Aufheizung der jeweils obersten, von der Rolle ablaufenden Metallfolienlage auf die gewünschte Temperatur.

Die Vorheiztemperatur der Metallfolie kann dabei in Abhängigkeit von der Preßbandtemperatur geregelt werden. Auch ist es möglich, die Vorheiztemperatur der Kerne 24, 25 in Abhängigkeit von der Temperatur der jeweils von der Vorratsrolle ablaufenden, obersten Metallfolienlage zu regeln.

Weiterhin wurde gefunden, daß es zur Vermeidung einer Faltenbildung wichtig ist, die vorgeheizte Metallfolie beim Einlaufen in die Doppelbandpresse an das Preßband anzudrücken. Bei der Ausführungsform gemäß Fig. 1 geschieht dies dadurch, daß die Schwenkarme 22, 23, welche die Vorratsrolle 19, 21 tragen, mit bestimmter Kraft im Bereich der Umlenktrommeln 5, 7 an das Preßband angepreßt werden, wobei die Umlenktrommeln 5, 7 als Widerlager dienen. Die Anpreßkraft kann dabei aus Kraftspeichern gewonnen werden, die in Fig. 1 schematisch durch Federn 28, 29 angedeutet sind.

Um das Eindringen von Verunreinigungen in das metallkaschierte Laminat zu vermeiden, ist es wichtig, die Metallfolie, insbesondere an der Einlaufseite der Vorrichtung, abzuschirmen. Dies geschieht bei der Vorrichtung gemäß Fig. 1 durch eine Verkleidung 31, 32, welche unmittelbar an eine Verkleidung 33 bzw. 34 der Preßbänder 9, 11 anschließt und die gesamte Vorratsrolle 19, 21 samt Andrückstelle der Metallfolie auf die Preßbänder gegenüber der Umgebung abkapselt. Hierdurch ist in platzsparender Weise ein optimaler Schutz gewährleistet.

Um weiterhin dem Eindringen jeglicher Fremdkörper vorzubeugen, sind Abstreifer 35, 36 vorgesehen, die sowohl an der einen Seite der zulaufenden Metallfolien als auch an den Preßbändern angreifen. An den Metallfolien greift vorzugsweise eine elastische, z. B. aus Gummi bestehende Lippe 37 an, während ein Schälmesser 38 unter möglichst spitzem Winkel etwaige Harzrückstände vom Preßband abschabt. Die erwähnten Teile 37, 38 können, wie aus Fig. 1 ersichtlich, zu einer durchgehenden Rinne verbunden sein. In diese Rinne gelangende, von der Metallfolie oder vom Preßband abgenommene Fremdkörper können durch ein Löse- oder Spülmittel aus den Verkleidungen 31, 32 herausgeführt werden. Das Löse- oder Spülmittel kann nach entsprechender Filtrierung wieder verwendet werden.

Schließlich können im Bereich der Umlenktrommeln 5, 7 Reibrollen 39, 41 angeordnet sein, die dort an den auf die Preßbänder 9, 11 aufgelegten Metallfolien angreifen und diese seitlich faltenfrei ziehen. Die Ausbildung und Anordnung dieser Reibrollen wird später noch beschrieben.

Die Abstreifer 35, 36 werden in herkömmlicher Weise mit bestimmtem Preßdruck gegen die zu reinigenden Oberflächen angelegt. Da bei der Ausführungsform gemäß Fig. 1 der Durchmesser der Vorratsrolle 19, 21 stetig abnimmt, wird den Abstreifern 35, 36 in an sich bekannter Weise eine Nachführeinrichtung zugeordnet, welche dafür sorgt, daß die Lippe 37 stets dicht an der zuoberst liegenden Metallfolienlage der Vorratsrolle anliegt.

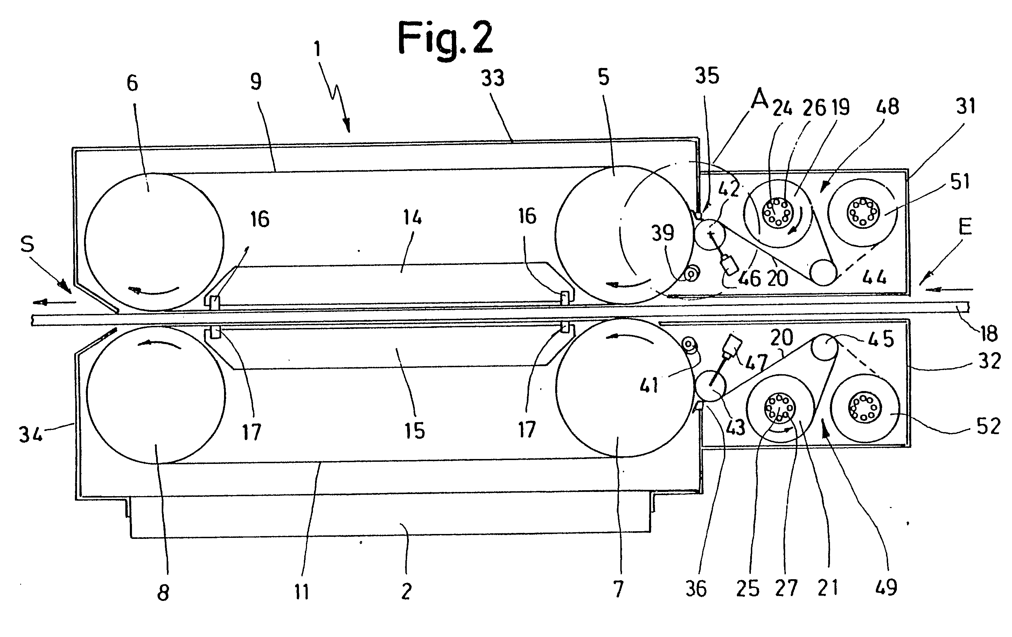

Bei der in Fig. 2 dargestellten, abgewandelten Ausführungsform der Erfindung ist der Aufbau der Doppelbandpresse 1 lediglich durch die wichtigsten Umrißlinien dargestellt. Einander entsprechende Teile sind in Fig. 1 und 2 jeweils mit den gleichen Bezugszeichen bezeichnet. Der wesentliche Unterschied der Vorrichtungen gemäß Fig. 1 und 2 besteht darin, daß in Fig. 2 die Metallfolie 20 nicht unmittelbar von den Vorratsrollen 19, 21 auf die Preßbänder 9, 11 aufläuft und von diesen Rollen gegen die Preßbänder angedrückt wird, sondern daß statt dessen zwischen Vorratsrolle und Preßband eine Umlenkwalze 42 bzw. 43 angeordnet ist. Die Metallfolie 20 wird über eine weitere Umlenkwalze 44 bzw. 45 von den Vorratsrollen 19, 21 abgezogen, über die Umlenkwalzen 42, 43 geführt und von diesen im Bereich der Umlenktrommeln 5, 7 der Doppelbandpresse 1 gegen das Preßband 9 bzw. 11 angedrückt. Hierdurch ist das Problem des stetig abnehmenden Durchmessers der Vorratsrolle 19, 21 behoben. Die Kerne der Vorratsrolle 19, 21 sind auch bei der Anordnung gemäß Fig. 2 wiederum beheizt und sorgen für eine gleichmäßige Erwärmung der zulaufenden Metallfolie 20. An den Umlenkwalzen 42, 43 greifen Kraftspeicher, beispielsweise in Form von Kolben-Zylinder-Aggregaten 46, 47, an und sorgen für gleichmäßigen Anpreßdruck der Metallfolien an die Preßbänder. Die Vorratsrollen 19, 21 und die Umlenkwalzen 42, 43 sind wiederum in einem von einer Verkleidung 31 bzw. 32 eingekapselten Reinluftraum 48 bzw. 49 angeordnet. Die Reinlufträume 48, 49 enthalten weiterhin Ersatzvorratsrollen 51, 52 für Metallfolie. Diese Vorratsrollen gelangen dann zum Einsatz, wenn die Vorratsrollen 19, 21 aufgebraucht sind. Ferner sind wiederum Abstreifer 35, 36 vorgesehen, die Verunreinigungen von der Metallfolie und vom Preßband abnehmen.

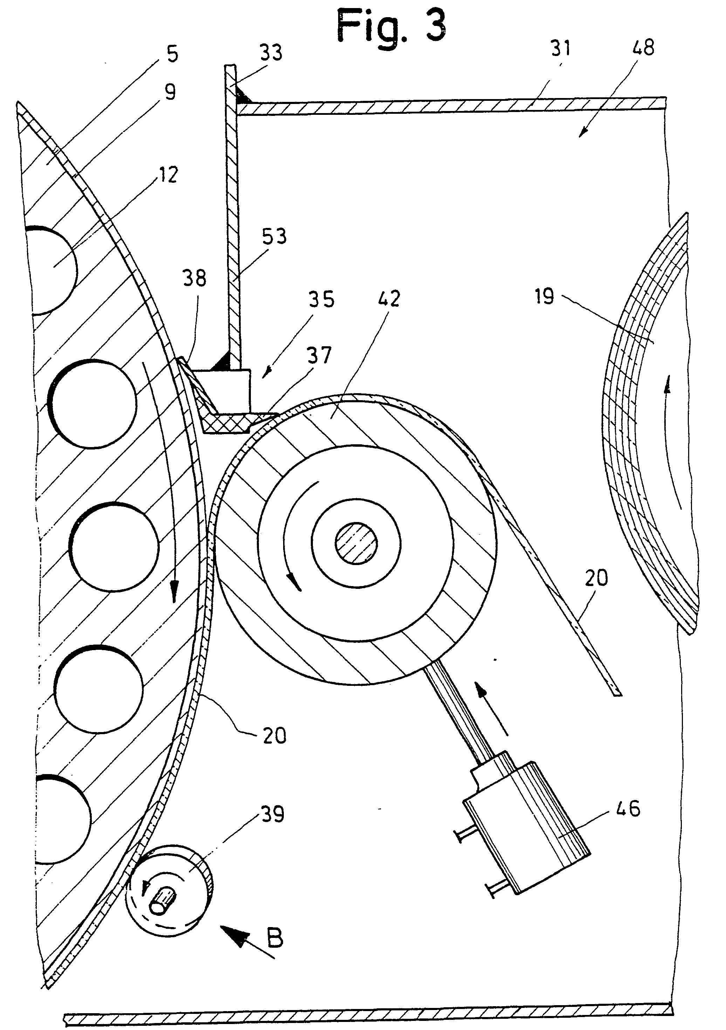

Die Fig. 3 zeigt gegenüber Fig. 2 stark vergrößert die Anordnung des Abstreifers 35 und der Umlenkwalze 42. Der Abstreifer 35 besteht wieder aus einer an der Metallfolie 20 angreifenden, elastischen Lippe 37 sowie einem damit fest verbundenen Schälmesser 38, welches am Preßband 9 angreift. Da für die Lippe 37 und das Messer 38 die Umlenkwalze 42 bzw. die Umlenktrommel 5 entsprechende Widerlager bilden, können diese Abstreifeinrichtungen mit erheblichem Druck an den betreffenden Flächen angreifen, wodurch die Reinigungswirkung verbessert ist. Die Lippe 37 und das Messer 38 bilden wiederum eine stirnseitig verschlossene Rinne, aus welcher Fremdkörper, z. B. mittels einer Spüllösung, abgeführt werden können.

Wie in Fig. 3 dargestellt, ist der Abstreifer 35 unmittelbar an der freien Kante einer gemeinsamen Wand 53 der Verkleidungen 31 und 33 angeordnet. Auf diese Weise dient der Abstreifer 35 gleichzeitig als Abdichtung dieser Verkleidungen im Einlaufbereich der Metallfolie 20.

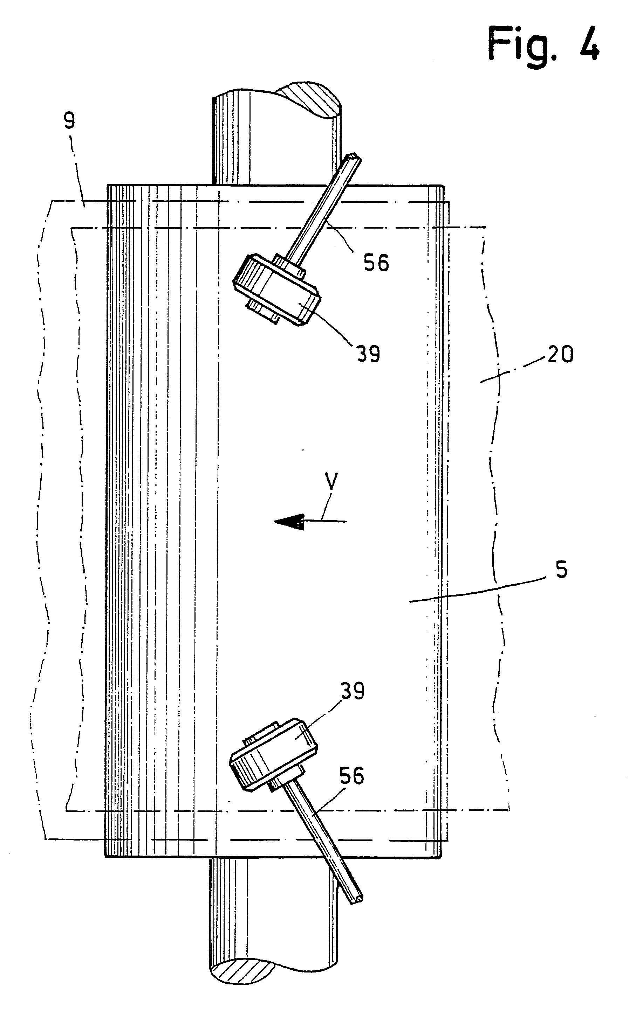

Die Fig. 4 zeigt, wie die erwähnten Reibrollen 39 an der Metallfolie 20 im Bereich der Umlenktrommel 5 angreifen. Die Achsen 56 verlaufen schräg zur Vorschubrichtung V der Metallfolie 20, so daß die an der Folie angreifenden Reibrollen 39 eine jeweils zum Rand der Folie hin gerichtete Kraftkomponente erzeugen, durch welche die Folie seitlich faltenfrei gezogen wird.

Bei den hier dargestellten und beschriebenen Ausführungsformen der Erfindung sind die Metallfolien-Vorratsrollen 19, 21 jeweils an der Einlaufseite E der Vorrichtungen angeordnet. Bei abgewandelten Ausführungsformen könnten diese Vorratsrollen mit Zubehör in ganz entsprechender Weise auch an der Auslaufseite S angeordnet sein. Hierdurch wird die vorgeheizte Metallfolie unter Druck jeweils im Bereich der auslaufseitigen Umlenktrommeln 6, 8 auf die Preßbänder 9, 11 aufgelegt, und von diesen Bändern zur Einlaufseite E hin geführt. Da hierbei die Metallfolie längere Zeit auf den Preßbändern verweilt, bevor sie mit der Kernschicht 18 vereinigt wird, kann sich zwischen Preßband und Metallfolie ein besonders inniger Temperatur- und Wärmeausgleich vollziehen. Auch ein Aufbringen der vorgeheizten Metallfolie auf das jeweils oben bzw. unten zwischen den Umlenktrommeln ausgespannte Trum der Preßbänder 9, 11 ist möglich.

Bei wiederum anderen Ausführungsformen der Erfindung, wo es auf ein Abschälen von Harzrückständen nicht so sehr ankommt, kann das Schälmesser 38 ebenfalls durch eine Lippe aus Gummi oder anderem elastischen Material ersetzt werden, wobei diese Lippe vorzugsweise wiederum einstückig und gegebenenfalls unter Ausbildung einer Rinne mit der an der Metallfolie angreifenden Lippe verbunden sein kann. Es ist auch möglich, am Preßband Schälmesser und an einer räumlich getrennten Stelle elastische Lippen abstreifend einwirken zu lassen.

**Patentansprüche**

1. Verfahren zur kontinuierlichen Herstellung metallkaschierter Laminate, insbesondere zur Anfertigung elektrischer Leiterplatten, aus einer elektrisch isolierenden Kernschicht und aus einer eine oder beide Oberflächen dieser Schicht bedeckenden Metallfolie, wobei die Metallfolie auf einer Vorratsrolle aufgewickelt ist und in diesem Zustand vorgeheizt, hierauf von der Vorratsrolle abgewickelt und schließlich mit der Kernschicht verbunden wird, dadurch gekennzeichnet, daß die Vorheizung der Metallfolie von einem heizbaren Kern der Vorratsrolle aus vorgenommen und die vorgeheizte Metallfolie in einer Doppelbandpresse unter Einwirkung von Druck und Wärme mit der Kernschicht verbunden wird.

2. Verfahren nach Anspruch 1, dadurch gekennzeichnet, daß die Vorheiztemperatur der Metallfolie in Abhängigkeit von der Preßbandtemperatur der Doppelbandpresse geregelt wird.

3. Verfahren nach Anspruch 2, dadurch gekennzeichnet, daß die Vorheiztemperatur des Kernes der Vorratsrolle in Abhängigkeit von der Temperatur der jeweils von der Vorratsrolle ablaufenden, obersten Metallfolienlage geregelt wird.

4. Verfahren nach einem der Ansprüche 1 bis 3, dadurch gekennzeichnet, daß die vorgeheizte Metallfolie beim Einlaufen in die Doppelbandpresse an das Preßband der Presse angedrückt wird.

5. Verfahren nach Anspruch 4, dadurch gekennzeichnet, daß die Metallfolie im Bereich einer Umlenktrommel der Presse an das Preßband angepreßt wird.

6. Verfahren nach einem der voranstehenden Ansprüche, dadurch gekennzeichnet, daß die beheizte Metallfolien-Vorratsrolle und der Andrückbereich der Folie an das Preßband in einem gemeinsamen Reinluftraum angeordnet werden.

7. Verfahren nach einem der voranstehenden Ansprüche, dadurch gekennzeichnet, daß die Metallfolie auf dem Preßband seitlich faltenfrei gezogen wird.

8. Vorrichtung zur Durchführung des Verfahrens nach einem der voranstehenden Ansprüche, gekennzeichnet durch eine Doppelbandpresse (1) und mindestens eine Metallfolien-Vorratsrolle (19, 21), wobei ein Kern (24, 25) der Vorratsrolle (19, 21) mit einer Heizeinrichtung (26, 27) versehen ist.

9. Vorrichtung nach Anspruch 8, dadurch gekennzeichnet, daß die Vorratsrolle (19, 21) schwenkbar gelagert und durch Andrückmittel (28, 29 ; 46, 47) derart gegen das Preßband (9, 11) bewegbar ist, daß sich die zulaufende Metallfolie (20) unter Druck gegen das Preßband legt.

10. Vorrichtung nach Anspruch 8, dadurch gekennzeichnet, daß die zulaufende Metallfolie (20) durch eine zwischen Vorratsrolle (19, 21) und Preßband (9, 11) angeordnete Umlenkwalze (42, 43) an das Preßband angedrückt ist.

11. Vorrichtung nach Anspruch 8, 9 oder 10, dadurch gekennzeichnet, daß Abstreifer (35, 36) zum Entfernen von Fremdkörpern vom Preßband (9, 11) und Metallfolie (20) vorgesehen sind.

12. Vorrichtung nach Anspruch 11, dadurch gekennzeichnet, daß die Abstreifer (35, 36) innerhalb des Reinluftraumes (48, 49) im Bereich des Einlaufspaltes zwischen Metallfolie (20) und Preßband (9, 11) angeordnet sind.

13. Vorrichtung nach Anspruch 11 oder 12, dadurch gekennzeichnet, daß die am Preßband (9, 11) und Metallfolie (20) anliegenden Abstreifer (35, 36) gleichzeitig Dichtungen des Reinluftraumes (48, 49) gegenüber der Umgebung sind.

14. Vorrichtung nach Anspruch 11, 12 oder 13, dadurch gekennzeichnet, daß die Abstreifer (35, 36) als elastische Lippe ausgebildet sind.

15. Vorrichtung nach einem der Ansprüche 11 bis 14, dadurch gekennzeichnet, daß der am Preßband (9, 11) angreifende Abstreifer als Schälmesser (38) ausgebildet ist.

16. Vorrichtung nach einem der Ansprüche 11 bis 15, dadurch gekennzeichnet, daß die an Preßband (9, 11) und Metallfolie (20) angreifenden Abstreifer zu einer Rinne verbunden und die abgestreiften Fremdkörper durch Spülmittel aus der Rinne entfernbar sind.

17. Vorrichtung nach einem der Ansprüche 11 bis 16, dadurch gekennzeichnet, daß die Abstreifer (35, 36) unter Druck im Bereich von Umlenktrommel (5, 6), Vorratsrolle (19, 21) und Umlenkwalze (42, 43) an Preßband (9, 11) bzw. Metallfolie (20) angreifen.

18. Vorrichtung zur Durchführung des Verfahrens nach Anspruch 7, dadurch gekennzeichnet, daß wenigstens zwei zur Vorlaufrichtung (V) der Metallfolie (20) schräg verlaufende Reibrollen (39, 41) vorgesehen sind, welche die auf das Preßband (9, 11) aufgelegte Metallfolie (20) seitlich faltenfrei ziehen.

19. Vorrichtung nach einem der Ansprüche 8 bis 18, dadurch gekennzeichnet, daß die die Metallfolie mit Druck gegen das Preßband anlegende Vorratsrolle (19, 21) bzw. Umlenkwalze (42, 43) an der Ein- oder Auslaufseite (E bzw. S) der Doppelbandpresse (1) angeordnet ist.

**Claims**

1. A process for the continuous production of metal coated laminates, in particular for the manufacture of electrical printed circuit boards, from an electrically insulating core layer and a metal foil covering one or both surfaces of this layer, wherein the metal foil is wound onto a supply roll and preheated in this state, and is thence unwound from the supply roll and finally fixed to the core layer, characterized in that the preheating of the metal foil is performed outwards from a heatable core in the supply roll and the preheated metal foil is attached to the core layer in a double band press by the application of pressure and heat.

2. A process according to Claim 1, characterized in that the temperature to which the metal foil is preheated is controlled according to the temperature of the press bands of the double band press.

3. A process according to Claim 2, characterized in that the preheating temperature of the core of the supply roll is controlled according to the temperature of the, at that time, uppermost layer of the metal foil unwinding from the supply roll.

4. A process according to one of Claims 1 to 3, characterized in that the preheated metal foil is pressed against the press band of the press when it enters the double band press.

5. A process according to Claim 4, characterized in that the metal foil is pressed against the press band near a guide cylinder of the press.

6. A process according to one of the preceding Claims, characterized in that the heated metal foil supply roll and the region in which the foil is pressed against the press band are situated in a common clean air chamber.

7. A process according to one of the preceding Claims, characterized in that the metal foil on the press band is drawn out sideways without any creases.

8. A device for performing the process according to one of the preceding Claims, characterized by a double band press (1) and at least one metal foil supply roll (19, 21), wherein a core (24, 25) of the supply roll (19, 21) is provided with a heating device (26, 27).

9. A device according to Claim 8, characterized in that the supply roll (19, 21) is pivotably mounted and can be moved against the press band (9, 11) by pressing means (28, 29 ; 46, 47) so that the metal foil (20) being fed through it is applied against the press band under pressure.

10. A device according to Claim 8, characterized in that the metal foil (20) being fed through it is pressed against the press band by means of a guide roller (42, 43) arranged between the supply roll (19, 21) and the press band (9, 11).

11. A device according to Claim 8, 9 or 10, characterized in that wipers (35, 36) are provided to remove foreign bodies from the press band (9, 11) and metal foil (20).

12. A device according to Claim 11, characterized in that the wipers (35, 36) are situated inside the clean air chamber (48, 49) between the metal foil (20) and press band (9, 11) near the input slot.

13. A device according to Claim 11 or 12, characterized in that the wipers (35, 36) applied against the press band (9, 11) and metal foil (20) at the same time form seals of the clean air chambers (48, 49) against the environment.

14. A device according to Claim 11, 12 or 13, characterized in that the wipers (35, 36) are formed as elastic lips.

15. A device according to one of Claims 11 to 14, characterized in that the wiper acting on the press band (9, 11) is formed as a paring knife (38).

16. A device according to one of Claims 11 to 15, characterized in that the wipers acting on the press band (9, 11) and metal foil (20) are connected to a channel and the foreign bodies which are wiped off can be removed from the channel by washing means.

17. A device according to one of Claims 11 to 16, characterized in that the wipers (35, 36) touch the press band (9, 11) or metal foil (20) under pressure near guide cylinders (5, 6), supply rolls (19, 21) and guide rollers (42, 43).

18. A device for performing the process according to Claim 7, characterized in that at least two friction rollers (39, 41) directed at an angle to the direction of advance (V) of the metal foil (20) are provided, which draw out sideways, without creases, the metal foil (20) applied against the press band (9, 11).

19. A device according to one of Claims 8 to 18, characterized in that the supply roll (19, 21) or guide roller (42, 43) which applies the metal foil under pressure against the press band is arranged at the input or output (E or S) end of the double band press (1).

**Revendications**

1. Procédé pour la fabrication continue de produits stratifiés à couche métallique, en particulier pour la préparation de plaquettes de circuits imprimés électriques, à partir d'une couche interne isolante électriquement et d'une feuille métallique couvrant une ou les deux faces extérieures de cette couche, la feuille métallique étant enroulée sur une bobine d'alimentation et étant préchauffée dans cet état, puis déroulée de la bobine d'alimentation et finalement assemblée avec la couche interne, caractérisé en ce que le préchauffage de la feuille métallique est effectué à partir d'un noyau chauffable de la bobine d'alimentation et la feuille métallique préchauffée est réunie à la couche interne dans une presse à double bande sous l'effet de la pression et de la chaleur.

2. Procédé selon la revendication 1, caractérisé en ce que la température de préchauffage de la feuille métallique est régulée en fonction de la température de la bande presseuse de la presse à double bande.

3. Procédé selon la revendication 2, caractérisé en ce que la température de préchauffage du noyau de la bobine d'alimentation est régulée en fonction de la température de la couche supérieure de la feuille métallique se déroulant de la bobine d'alimentation.

4. Procédé selon l'une des revendications 1 à 3, caractérisé en ce que la feuille métallique préchauffée est serrée contre la bande presseuse de la presse à l'entrée de la presse à double bande.

5. Procédé selon la revendication 4, caractérisé en ce que la feuille métallique est serrée contre la bande presseuse dans la région d'un tambour de renvoi de la presse.

6. Procédé selon l'une quelconque des revendications précédentes, caractérisé en ce que la bobine d'alimentation en feuille métallique préchauffée et la zone de serrage de la feuille contre la bande presseuse sont disposées dans une chambre commune à air purifié.

7. Procédé selon l'une quelconque des revendications précédentes, caractérisé en ce que la feuille métallique est tirée en sens latéral sans pli sur la bande presseuse.

8. Dispositif pour la mise en œuvre du procédé selon l'une quelconque des revendications précédentes, caractérisé par une presse à double bande (1) et au moins une bobine d'alimentation en feuilles métalliques (19, 21), dans laquelle un noyau (24, 25) de la bobine d'alimentation (19, 21) est prévu avec un dispositif de chauffage (26, 27).

9. Dispositif selon la revendication 8, caractérisé en ce que la bobine d'alimentation (19, 21) est montée pivotante et elle est déplaçable par des moyens de serrage (28, 29 ; 46, 47) contre la bande presseuse (9, 11) de sorte que la feuille métallique (20) se déroulant est appliquée sous pression contre la bande presseuse.

10. Dispositif selon la revendication 8, caractérisé en ce que la feuille de métal (20) se déroulant est serrée contre la bande presseuse par un rouleau de renvoi (42, 43) disposé entre la bobine d'alimentation (19, 21) et la bande presseuse (9, 11).

11. Dispositif selon l'une des revendications 8, 9 et 10, caractérisé en ce qu'il est prévu des racloirs (35, 36) pour chasser les corps étrangers de la bande presseuse (9, 11) et de la feuille métallique (20).

12. Dispositif selon la revendication 11, caractérisé en ce que les racloirs (35, 36) sont disposées à l'intérieur de la chambre air purifié (48, 49) dans la zone de la fente d'entrée entre la feuille métallique (20) et la bande presseuse (9, 11).

13. Dispositif selon la revendication 11 ou 12, caractérisé en ce que les racloirs (35, 36) appliqués contre la bande presseuse (9, 11) et la feuille métallique (20) sont en même temps des joints d'étanchéité de la chambre à air purifié (48, 49) vis-à-vis de l'environnement.

14. Dispositif selon l'une des revendications 11, 12, et 13, caractérisé en ce que les racloirs (35, 36), ont la configuration de lèvres élastiques.

15. Dispositif selon l'une des revendications 11 à 14, caractérisé en ce que le racloir appliqué contre la bande presseuse (9, 11) a la configuration d'une lame à éplucher (38).

16. Dispositif selon l'une des revendications 11 à 15, caractérisé en ce que les racloirs appliqués contre la bande presseuse (9, 11) et la feuille métallique (20) sont réunis en une rigole et les corps étrangers chassés par le raclage sont chassés de la rigole par des moyens de lavage.

17. Dispositif selon l'une des revendications 11 à 16, caractérisé en ce que les racloirs (35, 36) s'appliquent sous pression respectivement contre la bande presseuse (9, 11) et la feuille métallique (20) dans la région du tambour de renvoi (5, 6), de la bobine d'alimentation (19, 21) et du rouleau de renvoi (42, 43).

18. Dispositif pour la mise en œuvre du procédé selon la revendication 7, caractérisé en ce qu'il est prévu au moins deux galets de frottement (39, 41) disposés en oblique par rapport au sens d'avancement (V) de la feuille métallique (20) qui tirent en sens latéral sans pli la feuille métallique (20) appliquée contre la bande presseuse (9, 11).

19. Dispositif selon l'une des revendications 8 à 18, caractérisé en ce que la bobine d'alimentation (19, 21) et le rouleau de renvoi (42, 43) qui appliquent respectivement sous pression la feuille métallique contre la bande presseuse sont disposés du côté de l'entrée (E) ou du côté de la sortie (S) de la presse à double bande (1).

# Fig.1

EP 0 144 822 B1

# Fig.2

EP 0 144 822 B1

EP 0 144 822 B1

# Fig. 3

# Fig. 4